# EUROPEAN PATENT APPLICATION

(11) **EP 2 031 091 A1**
(43) Date of publication of application: **04.03.2009**
(21) Application number: 08161949.6
(22) Date of filing: 06.08.2008
(51) Int. Cl.: C23C 30/00, C23C 16/06, C23C 16/40, C23C 16/04

(54) **Protective coating applied to metallic reactor components to reduce corrosion products released into a nuclear reactor environment**

(30) Priority: 16.08.2007 US 889757
(71) Applicant: GE-Hitachi Nuclear Energy Americas LLC, Wilmington, NC 28401 (US)
(72) Inventor: Dulka, Catherine P., West Chester, PA 19380 (US); Sandusky, David W., Santa Clara, CA 95030 (US); Kim, Young Jin, Saratoga, NY 12065 (US); Israel, Rajasingh S., Cuyahoga, OH 44145 (US)
(74) Representative: Szary, Anne Catherine

(57) **Abstract**

An insulating coating is applied to the metallic components in a nuclear reactor water environment to decrease and/or mitigate general corrosion and erosion-corrosion of the reactor component's metallic surfaces. Preferably, the coating is a 0.1 micron to 0.3 mm thin layer of an oxide coating such as titania (TiO₂), zirconia (ZrO₂), tantala (Ta₂O₅), Al₂O₃, CeO₂ or similar oxides; or a thin layer of the metal, such as Ti, Zr, Ta, Hf, Ce, Al, which will oxidize in the reactor water environment.. The applied coating provides a protective layer between the component surfaces and the reactor water environment. By reducing and/or eliminating the potential for corrosion on reactor metallic components, the coating eliminates or minimizes the potential for activated corrosion products to contaminate the reactor water. The coating is especially beneficial for nickel- alloy based metals that contribute significant cobalt-related corrosion products, and will also be effective on austenitic stainless steel components.

## Description

The present invention relates to protective coatings applied to metallic reactor components to reduce corrosion products release from the components.

### BACKGROUND OF THE INVENTION

Metallic components in a nuclear reactor water environment, e.g., boiling water reactors ("BWR"), pressurized water reactors ("PWR"), or Canada deuterium uranium ("CANDU") reactors, produce corrosion products. In cases where reactor components are made from nickel alloys, a concern arises about cobalt-containing corrosion products, which contaminate the reactor water with activated species, in particular, cobalt-60. Some cobalt is naturally present in nickel alloys as a tramp element. In addition, nickel isotopes can be transmuted to activated cobalt isotopes in the neutron flux. Specifically, the cobalt bearing corrosion product issues dominate the contamination issue. Cobalt becomes activated in the reactor neutron flux, and thus, there is a potential for contaminating the water with activated corrosion products. Activated corrosion products in reactor water can migrate to components and systems external to the reactor vessel, thereby causing elevated occupational exposure to workers.

U.S. Patent No. 6,630,202, titled "CVD Treatment of Hard Friction Coated Steam Line Plug Grips", demonstrates the protective nature of a chemical vapor deposited ("CVD") coating with regard to corrosion in a mild environment. U.S. Patent No. 6,633,623 supports the hard, erosion-corrosion resistant CVD coating in a boiling water reactor ("BWR") environment with regard to fouling.

### BRIEF DESCRIPTION OF THE INVENTION

The present invention is a method for reducing activated corrosion products, such as Co-60, from the corrosion of metallic components in a nuclear reactor water environment by applying an insulating coating to the component's surfaces. The insulating coating, such as titania (TiO₂), zirconia (ZrO₂), tantala (Ta₂O₅), alumina (Al₂O₃), hafnia (HFO₂), ceria (CeO₂) or similar oxides is applied by chemical vapor deposition ("CVD") or other coating methods to the component surfaces. Other coating processes such as thermal spray coating by plasma or HVOF, wire arc, PVD, RF sputtering and electroplating are also possible. The coating thickness can be in the 0.1 micron to 0.3 mm range, depending on the coating process. It is also noted that the coating can be applied as a metallic element, i.e., Ti, Zr, Ta, Al, Hf, Ce, *etc.* to be eventually oxidized in the reactor water to form the oxide, e.g., TiO₂. The coating provides a protective layer between the component surfaces and the reactor environment. The main purpose of the coating on reactor metallic components is to reduce and/or eliminate the potential for corrosion. In doing so, the potential for activated corrosion products contaminating the reactor water is thus eliminated or minimized. The coating is especially beneficial for nickel alloy-based metals that contribute significant cobalt-containing corrosion products. It would also be effective on austenitic stainless steel components, as stainless steels contain a significant amount of nickel, as well as some cobalt as a tramp element. For example, the CVD treatment applies a conformal surface coating, and in addition, fills the voids/pores in the metallic components. Furthermore, in previous patents, the hard, erosion-corrosion resistant, CVD coating has been shown to be resistant to the reactor water environment. Thus, by sealing the surface and the voids, the potential for moisture intrusion to the base metal is reduced and/or eliminated, thereby reducing the potential for corrosion and subsequent corrosion product release to the reactor water.

The present invention provides a thin insulating coating (or metallic coating which will oxidize in the reactor water environment) by CVD or other coating process on the exposed surfaces of reactor components that will be located in a reactor water environment. The preferred coating is titania, however, other oxide coatings can be tantala, zirconia, or other similar oxides that will not readily degrade from use in a reactor water environment. The advantages of the CVD surface treatment to the metallic components in the reactor water environment are as follows:
- Applies an insulating CVD coating of a minimum thickness (e.g., 0.1 to 5 microns);
- Allows for a conformal surface treatment, which covers all surfaces, including the insides of perforations, pores, spaces and crevices;
- Fills in the pores and/or spaces of metallic components with a hard oxide material, e.g., tantala, titania, zirconia, or other similar oxides, which will not readily degrade from reactor water and neutron exposure;
- Is a conformal surface treatment, which allows for covering the metallic surface and filling in any pores, spaces, crevices with the CVD material;
- The CVD treatment is erosion and corrosion resistant in the reactor water environment;
- The CVD treatment is a hard, adherent coating on the metallic surface;
- The CVD treatment can eliminate or reduce the release of corrosion products from metallic components entering the reactor water environment; and
- Thermal spray coatings by plasma or High Velocity Oxygen Fuel Thermal Spray Process ("HVOF"), Physical vapor deposition ("PVD"), radio frequency ("RF") sputtering treatments, electroplating and electroless plating are alternative methods of applying such a coating on some components with a coating thickness of 5 microns to 0.3 mm.
- The metallic element, such as Ti, Ta, Al, Zr, Hf, Ce, etc can be applied as a protective coating that will eventually oxidize in the reactor water environment.

### BRIEF DESCRIPTION OF THE DRAWINGS

Figure 1 shows the conformal nature and strong adhesion of a chemical vapor deposited insulating oxide coating.
Figure 2 is a scanning electron micrograph of a stainless steel surface with a CVD treatment showing the estimated corrosion rate of a titania (TiO₂) coating under simulated high temperature and high flow water.
Figure 3 is a graph of the adherent, erosion-corrosion resistant nature of a titania (TiO₂) coating.
Figures 4a and 4b show surface morphology of a hard friction resistance coating on a steam line plug grip with and without a tantala (Ta₂O₅) coating after salt-spray testing.
Figure 5 shows a cross-sectional view of a tantala (Ta₂O₅) layer produced by CVD, showing that the tantala layer was deposited along the surface of cracks and pores in a hard friction resistance coating layer.

### DETAILED DESCRIPTION OF THE INVENTION

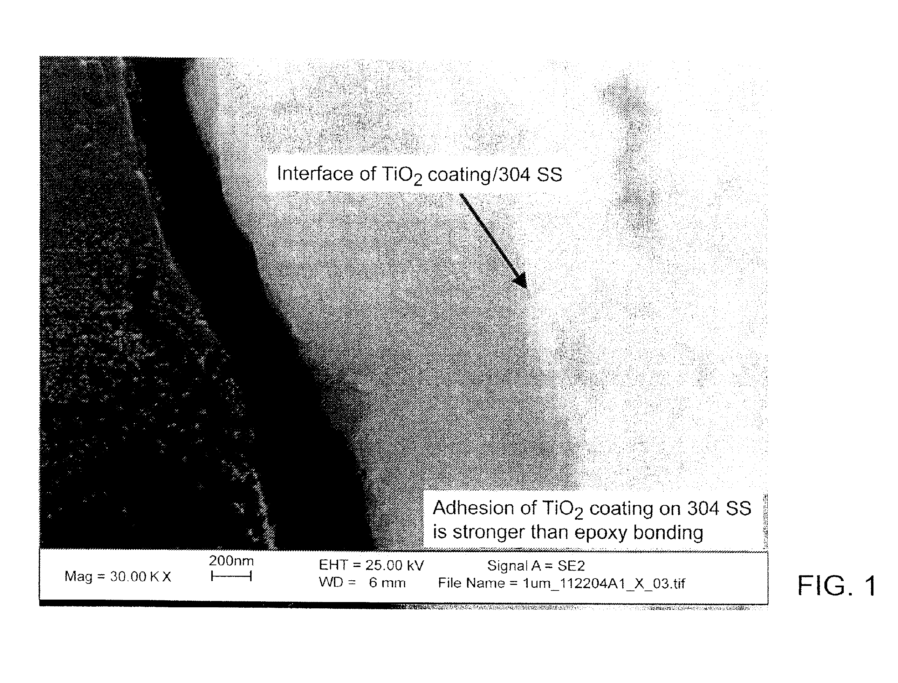

Various metal oxides, e.g., TiO₂, Ta₂O₅, ZrO₂, Al₂O₃, HfO₂, and CeO₂ that may be applied by chemical vapor deposition (CVD) are materials widely used as corrosion barrier layers due to their thermal and chemical stability and low coefficient of thermal expansion. The main characteristic of refractory oxides is an excellent corrosion resistance under various corrosive and high temperature environments. Thus, coating a metallic component in a reactor water environment eliminates and/or mitigates the potential for the component to corrode, and thereby contaminate the reactor water with activated species. Nickel alloy components are of most concern because of the high level of cobalt contribution. The CVD treatment, as seen in Figure 1, produces a conformal coating over the surface of a metal part, which fills the voids/spaces and protects the base metal of the part from corrosion. As a result of the treatment, the base metal alloy is protected from the reactor water environment and the resulting corrosion and loss of corrosion products into the water. These corrosion-inhibiting coatings have been used on parts in gas turbines, aircraft engines, impellers, valves, and other components/surfaces, which experience corrosion. One such application proposed for this coating is spacer assemblies that maintain position of the individual fuel rods in the BWR fuel bundles. For some designs, these spacers are made of nickel Alloy X-750. There are several spacers in each fuel bundle so a significant surface area of nickel alloy is exposed to the reactor water environment. Since the spacers are directly in the core, they are highly irradiated, and consequently, have potential to release a significant quantity of activated corrosion products to the reactor water. Application of the oxide coating will significantly reduce or eliminate this release of activated corrosion products by isolating the nickel ally from the reactor water.

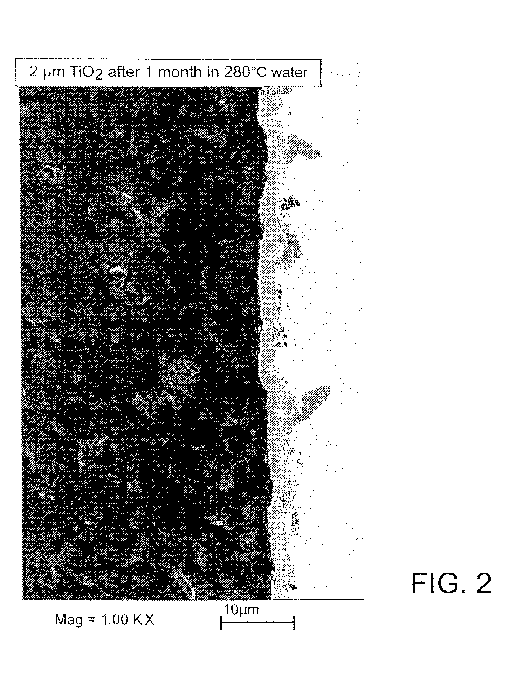

Figure 2 is a scanning electron micrograph ("SEM") of a stainless steel surface with the CVD treatment. The epoxy resin embedment was not able to pull away the TiO₂ coating layer from the 304SS substrate, and also failed to break the TiO₂ coating itself. This indicates the strong mechanical stability and adhesion of the TiO₂ coating produced by CVD to the metal substrate. Such a coating also has been used on various products, such as gas turbine and aircraft engine blades. Data reflecting these results is set forth in Table 1 below.

With regard to Figure 2, it is noted that after one month of submergence in a high flow electrode setup, the adhesive forces between the coating and the stainless steel surface did not change from their original values. Furthermore, it was found during this testing that the coating did not delaminate, but rather eroded slowly in the BWR environment. This erosion-corrosion rate has been measured during testing and a potential service life of greater than 20 years for the TiO₂ coating was extrapolated from the test results. Data reflecting these results is set forth in Table 1 below.

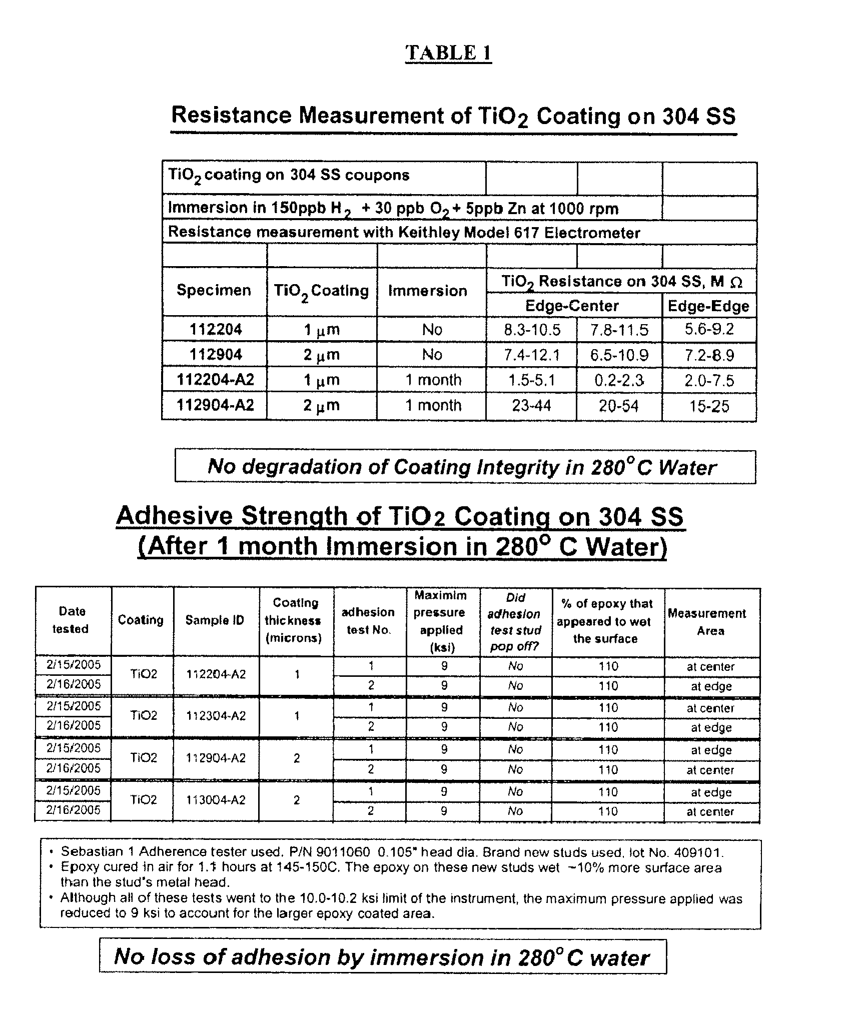

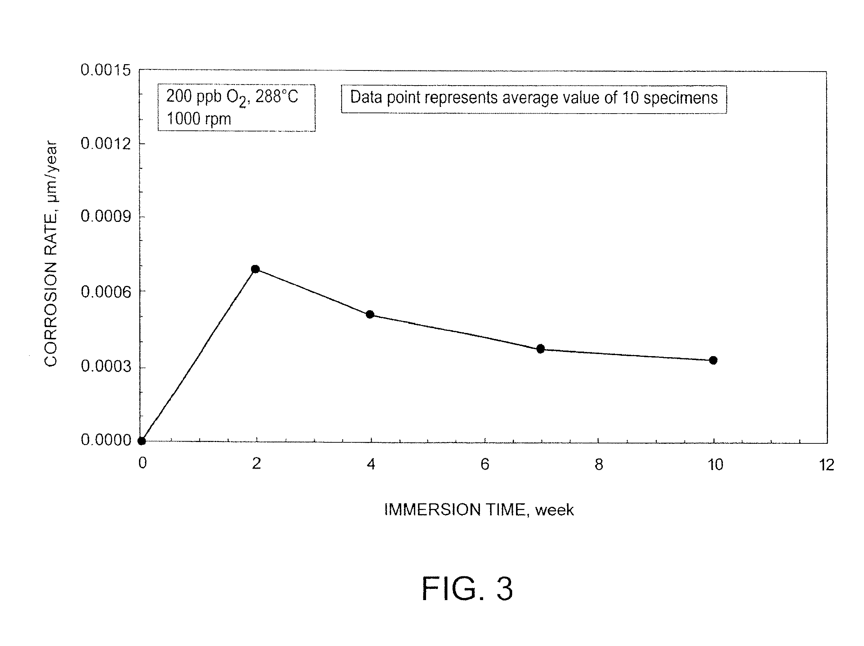

Figure 3 is a graph of the adherent, erosion-corrosion resistant nature of the TiO₂ coating. The corrosion resistant coatings, *e.g.,* Ta₂O₅ (tantala), TiO₂ (titania), Al₂O₃ (alumina), etc., are applied on the hard friction surfaces of steam line plug grips. The purpose of the coating is to fill pores and cracks in the friction surface by various coating methods, e.g., by PVD or CVD.

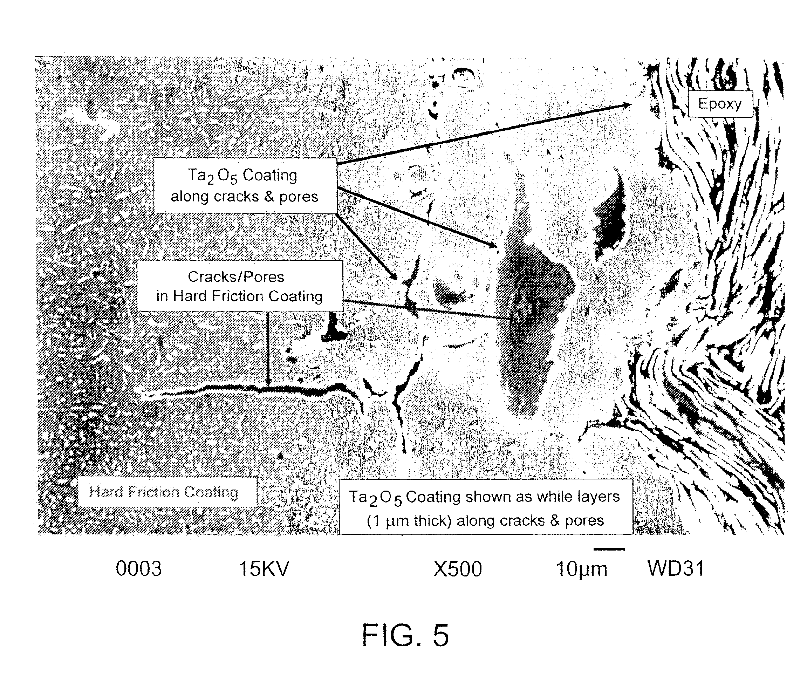

Figure 5 shows an SEM cross section of the CVD tantala layer deposited along the surface of cracks and pores in the hard friction layer of the steam line plug grips. It demonstrates the depth of coating into the pores/cracks/spaces. The effectiveness of the tantala corrosion resistant layer was evaluated by a salt spray method (ASTM Standards G112).

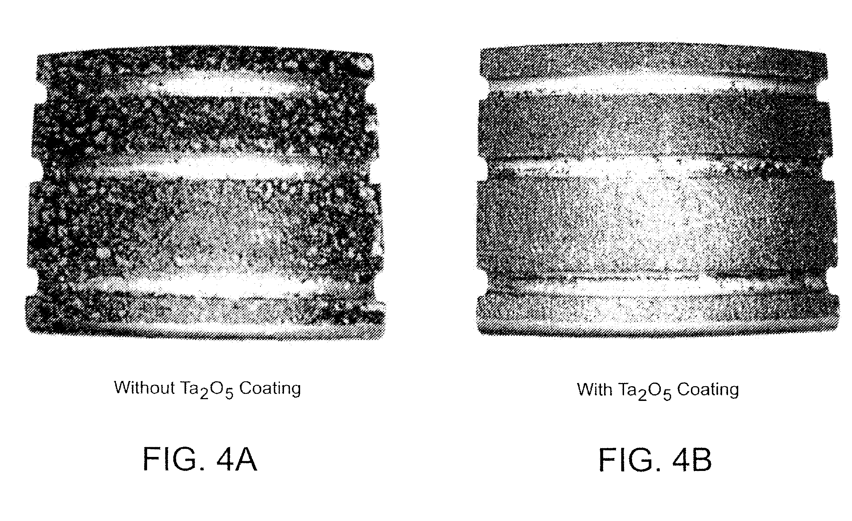

Figures 4a and 4b show corroded surface morphologies of the hard friction surface with and without a tantala coating after salt spray testing. Significant reduction or mitigation of corrosion of the friction surface by the tantala coating is visible.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of decreasing and/or mitigating corrosion of metallic components in a nuclear reactor water environment comprising the step of applying an insulating coating to the metallic components' surfaces.

2. The method of claim 1, wherein the nuclear reactor water environment is an environment selected from the group consisting of boiling water reactors ("BWR"), pressurized water reactors ("PWR"), and Canada deuterium uranium ("CANDU") reactors.

3. The method of claim 1 or claim 2 further comprising the step of applying the insulating coating to the metallic component' surfaces so as to fill voids and/or pores in the metallic components.

4. The method of any preceding claim wherein the insulating coating is an oxide insulating coating or is a metallic coating that oxidizes in the reactor water environment.

5. The method of Claim 4 wherein the oxide insulating coating is selected from the group consisting of TiO₂, ZrO₂, Ta₂O₅, Al₂O₃, CeO₂ and HfO₂ and wherein the metallic coating is selected from the group consisting of Ti, Zr, Ta, Al, Ce and Hf.

6. The method of any preceding claim, wherein the step of applying the insulating coating to the metallic components' surfaces further comprises using an application method of chemical vapor deposition ("CVD") with a thickness substantially within the range of 0.1 to 5 microns; or wherein the step of applying the insulating coating to the metallic components' surfaces further comprises using an application method selected from the group consisting of thermal spray coatings by plasma or high velocity oxygen fuel thermal spray process ("HVOF"), physical vapor deposition ("PVD"), radio frequency ("RF") sputtering treatments, electroplating and electroless plating.

7. The method of claim 6, wherein the step of applying the insulating coating to the metallic components' surfaces further comprises applying the coating with a thickness substantially within the range of 0.1 micron to 0.3 mm.

8. The method of any preceding claim, wherein the coating is erosion and corrosion resistant in the nuclear reactor water, the nuclear reactor water including heavy water.

9. The method of any preceding claim, wherein the coating is a 0.1 micron to 0.3 mm thin layer of an oxide or a metallic element, *i.e.,* Ti, Zr, Ta, Al, Hf, Ce, *etc.* to be eventually oxidized in the reactor water to form the oxide, e.g., TiO₂.

10. The method of any preceding claim further comprising the step of applying the insulating coating to the metallic components' surfaces so as to apply a conformal surface treatment to the surfaces.

11. A method of decreasing and/or mitigating corrosion of metallic components in a nuclear reactor water environment comprising the step of applying a coating to the metallic components' surfaces, so as to apply a conformal surface treatment to the surfaces and thereby fill voids and/or pores in the metallic components.

12. The method of claim 11 wherein the coating is an oxide insulating coating selected from the group consisting of TiO₂, ZrO₂, Ta₂O₅, Al₂O₃, CeO₂ and HfO₂ or wherein the coating is a metallic coating that oxidizes in the reactor water environment and that is selected from the group consisting of Ti, Zr, Ta, Al, Ce and Hf.

13. The method of claim 11 or claim 12 wherein the coating is applied using a application method selected from the group consisting of Chemical vapor deposition ("CVD"), thermal spray coatings by plasma or high velocity oxygen fuel thermal spray process ("HVOF"), physical vapor deposition ("PVD"), radio frequency ("RF") sputtering treatments, electroplating and electroless plating.

14. The method of claim 12, wherein the step of applying the oxide insulating coating to the metallic components' surfaces further comprises applying the oxide coating with a minimum thickness substantially within the range of 0.1 to 5 microns.

15. The method of claim 13, wherein the step of applying the coating to the metallic components' surfaces further comprises applying the coating with a thickness substantially within the range of 0.1 micron to 0.3 mm.
